# EUROPEAN PATENT APPLICATION

(11) **EP 1 821 340 A1**
(43) Date of publication of application: **22.08.2007**
(21) Application number: 05788280.5
(22) Date of filing: 30.09.2005
(51) Int. Cl.: H01L 21/337, H01L 29/808

(54) **BIDIRECTIONAL FIELD-EFFECT TRANSISTOR AND MATRIX CONVERTER**

(30) Priority: 09.12.2004 JP 2004356947
(71) Applicant: Sumitomo Electric Industries, Ltd., Osaka-shi, Osaka 541-0041 (JP)
(72) Inventor: FUJIKAWA, K., SUMITOMO ELECTRIC INDUSTRIES, LTD., Osaka-shi, Osaka 5548511 (JP)
(74) Representative: Grünecker, Kinkeldey, Stockmair & Schwanhäusser Anwaltssozietät
(86) International application number: PCT/JP2005/018137
(87) International publication number: WO 2006/061942

(57) **Abstract**

The present invention provides a bi-directional field effect transistor and a matrix converter using the same, in which a current flowing bi-directionally can be controlled by means of a single device.

The bi-directional field effect transistor includes: a semiconductor substrate 1; a gate region which is arranged on the semiconductor substrate 1, with a channel parallel to a principal surface of the substrate 1 and a gate electrode 13a for controlling conductance of the channel; a first region which is arranged on a first side of the channel; and a second region which is arranged on a second side of the channel; wherein a forward current which flows from a first electrode 11a of the first region through the channel to a second electrode 12a of the second region and a backward current which flows from the second electrode 12a through the channel to the first electrode 11a can be controlled by a gate voltage applied to the gate electrode 13a.

## Description

### [TECHNICAL FIELD]

The present invention relates to bidirectional field-effect transistors, which can control a current flowing bi-directionally, and a matrix converter using the transistors.

### [BACKGROUND]

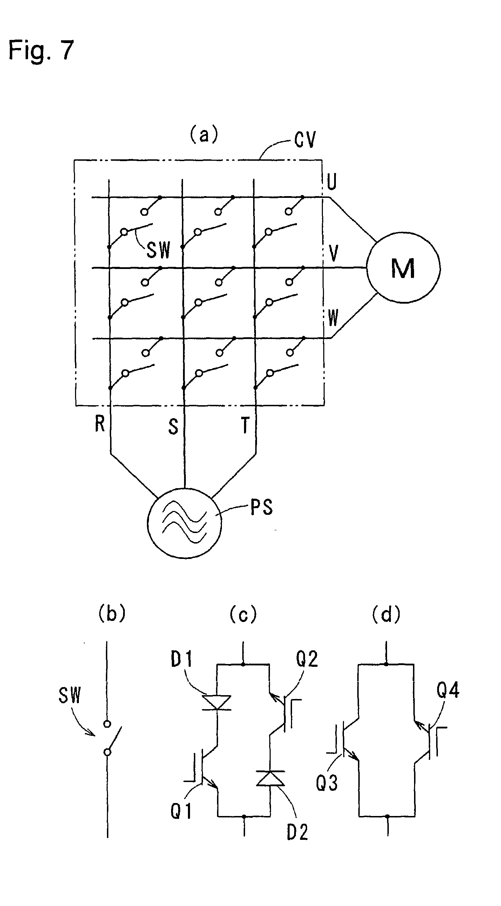

Fig. 7a is a circuit diagram showing an example of a conventional matrix converter. Figs. 7b to 7d are circuit diagrams of switching devices. The matrix converter CV has function of converting an AC (alternating current) power having a frequency to another AC power having a different frequency.

A three-phase AC power source PS supplies a three-phase AC power having a frequency Fa through three lines R, S and T. A three-phase AC motor M is driven by another three-phase AC power having another frequency Fb, which is supplied through three lines U, V and W.

The matrix converter CV includes the input lines R, S and T, the output lines U, V and W, and nine switching devices SW, which are arranged in matrix between the respective lines R, S and T and the respective lines U, V and W, for controlling opening and closing between the mutual lines. Each of the switching devices SW is driven by a control circuit (not shown) which can operate PWM (pulse width modulation) with desired timings.

Since each of the switching devices SW must open and close the AC current flowing forward and backward, a common power transistor cannot perform this operation. Hence, certain ingenuity of circuit arrangement is required.

In the conventional matrix converter, as shown in Fig. 7c, a first series circuit having an IGBT (Insulated Gate Bipolar Transistor) device Q1 and a diode device D1, and a second series circuit having an IGBT device Q2 and a diode device D2 are connected in anti-parallel with each other, to constitute a single switching device SW. Since IGBT devices can control only one-way current, such anti-parallel connection can control the bidirectional current. In addition, IGBT devices have a low reverse blocking voltage, therefore, the reverse blocking voltage can be improved by using the series-connected diode device.

In the above-described circuitry, however, four power device are needed to constitute the single switching device SW. In the case of three-phase to three-phase conversion shown in Fig. 7a, thirty-six power devices are needed to constitute the nine switching device SW. Further, each power device must have larger ratings of voltage and current, thereby resulting in larger scale of circuitry and a larger cooling mechanism for dissipating a great deal of heat.

In order to solve these problems, RB(Reverse Blocking)-IGBT devices, as shown in Fig. 7d, have been proposed in the following non-patent document 1.

[NON-PATENT DOCUMENT 1] Proceedings of 2004 International Symposium on Power Semiconductor Devices & ICs, Kitakyushu, pp. 121-124

### [DISCLOSURE OF THE INVENTION]

### [PROBLEM TO BE SOLVED BY THE INVENTION]

The RB-IGBT device, which is integrated with a diode area on a side of a semiconductor substrate on which an IGBT device is formed, is equivalent in circuitry to the series circuit having the IGBT device and the diode device shown in Fig. 7c.

Even in the case of using RB-IGBT devices, however, two RB-IGBT devices must be connected in anti-parallel with each other to control the bidirectional current. Hence, two power devices are needed to constitute the single switching device SW, resulting in larger scale of circuitry and a larger cooling mechanism.

It is an object of the present invention to provide a bidirectional field-effect transistor, which can control a current flowing bi-directionally by means of a single device.

Further, it is another object of the present invention to provide a matrix converter with a smaller size and a larger capacity by using the bidirectional field-effect transistors.

### [MEANS FOR SOLVING THE PROBLEM]

In order to achieve the object, a bidirectional field-effect transistor according to the present invention, includes:
a semiconductor substrate;
a gate region which is formed on the semiconductor substrate, the region including a channel parallel to a principal surface of the substrate, and a gate electrode for controlling conductance of the channel;
a first region which is provided on a first side of the channel; and
a second region which is provided on a second side of the channel;
wherein both of a first current flowing from the first region through the channel to the second region and a second current flowing from the second region through the channel to the first region are controlled by a gate voltage applied to the gate electrode.

It is preferable in the present invention that the gate region is arranged in the center of the first region and the second region.

Further, it is preferable in the present invention that an interval between the gate electrode and a first electrode residing in the first region is substantially equal to another interval between the gate electrode and a second electrode residing in the second region.

Furthermore, it is preferable in the present invention that an interval between the channel of the gate region and a first contact layer residing in the first region is substantially equal to another interval between the channel of the gate region and a second contact layer residing in the second region.

Moreover, it is preferable in the present invention that the transistor is of junction type wherein the gate region includes a p-n junction.

Moreover, it is preferable in the present invention that the transistor is of MIS (Metal-Insulator-Semiconductor) type wherein the gate region includes a metal layer, an insulation layer and a semiconductor layer.

Moreover, it is preferable in the present invention that the transistor is of MES (Metal-Semiconductor) type wherein the gate region includes a Schottky junction of a metal and a semiconductor.

Further, it is preferable in the present invention that the semiconductor substrate is formed of SiC.

A matrix converter according to the present invention, includes:
a plurality of input lines in which alternating currents having a first frequency flow;
a plurality of output lines in which alternating currents having a second frequency flow;
a plurality of switching devices for controlling opening and closing between the respective input lines and the respective output lines;
wherein for the switching devices, the above-described bidirectional field-effect transistors are used.

### [EFFECT OF THE INVENTION]

According to the present invention, on the semiconductor substrate, the gate region including the channel parallel to the principal surface of the substrate is provided, and the first and the second regions are provided on the first and the second sides of the channel, respectively, thereby realizing a bidirectional field-effect transistor which can operate both in a forward mode where the first region acts as a source and the second region acts as a drain, and in a backward mode where the second region acts as a source and the first region acts as a drain. Both the forward current and the backward current can be controlled by the gate voltage applied to the gate electrode. Therefore, an alternating current flowing bi-directionally can be controlled by means of only a single device, and such an AC switching device having a smaller size and a larger capacity can be obtained.

Additionally, in the matrix converter which employs the bidirectional field-effect transistors for the switching devices, the number of such power devices can be remarkably reduced, thereby downsizing scale of circuitry and cooling mechanism and simplifying them as compared to the conventional converter.

### [BRIEF DESCRIPTION OF THE DRAWINGS]

Fig. 1a is a circuit diagram showing an example of a matrix converter according to the present invention. Figs. 1b and 1c are circuit diagram showing switching devices.
Fig. 2 is a cross-sectional view showing an example of a bidirectional field-effect transistor according to the present invention.
Fig. 3 is a cross-sectional view showing another example of a bidirectional field-effect transistor according to the present invention.
Fig. 4 is a cross-sectional view showing yet another example of a bidirectional field-effect transistor according to the present invention.
Fig. 5 is a cross-sectional view showing yet another example of a bidirectional field-effect transistor according to the present invention.
Fig. 6 is a cross-sectional view showing still another example of a bidirectional field-effect transistor according to the present invention.
Fig. 7a is a circuit diagram showing an example of a conventional matrix converter. Figs. 7b to 7d are circuit diagrams of switching devices.

### [EXPLANATORY NOTE]

- 1: SUBSTRATE
- 2: BUFFER LAYER
- 3 .: CHANNEL LAYER
- 4: RESURF LAYER
- 10a: COMMON ELECTRODE
- 11a: FIRST ELECTRODE
- 11, 12: N⁺ CONTACT LAYER
- 12a: SECOND ELECTRODE
- 13: P⁺ LAYER
- 13a: GATE ELECTRODE
- 13b: FIELD PLATE
- 14, 16: INSULATION LAYER
- 15: P LAYER
- CV: MATRIX CONVERTER

### [BEST EMBODIMENT FOR CARRYING OUT THE INVENTION]

### (First Embodiment)

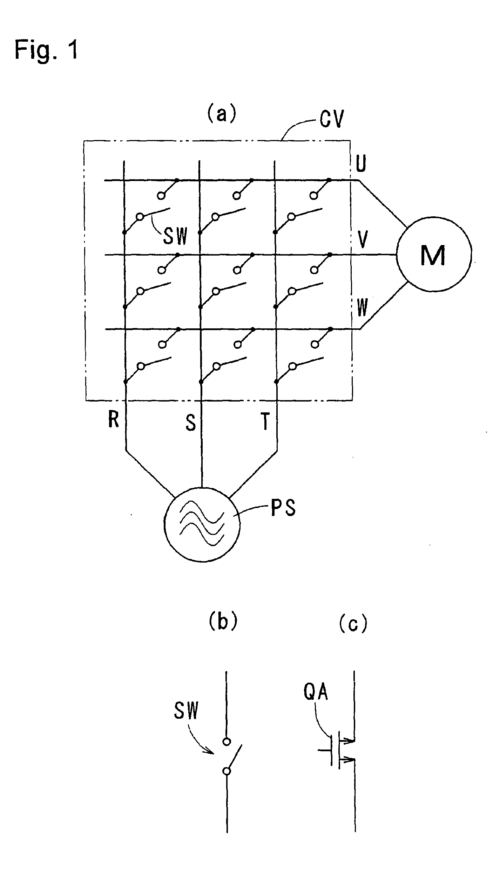

Fig. 1a is a circuit diagram showing an example of a matrix converter according to the present invention. Figs. 1b and 1c are circuit diagram showing switching devices. The matrix converter CV has function of converting an AC power having a frequency to another AC power having a different frequency. Herein, three-phase to three-phase conversion will be exemplified. But the present invention can be also applied to three-phase to single-phase conversion, three-phase to single-phase conversion, single-phase to three-phase conversion, single-phase to single-phase conversion, as well as M-phase to N-phase conversion.

A three-phase AC power source PS supplies a three-phase AC power having a frequency Fa through three lines R, S and T. A three-phase AC motor M is driven by another three-phase AC power having another frequency Fb, which is supplied through three lines U, V and W.

The matrix converter CV includes the input lines R, S and T, the output lines U, V and W, and nine switching devices SW, which are arranged in matrix between the respective lines R, S and T and the respective lines U, V and W, for controlling opening and closing between the mutual lines. Each of the switching devices SW is driven by a control circuit (not shown) which can operate PWM (pulse width modulation) with desired timings.

In this embodiment, bidirectional field-effect transistors QA as shown in Fig. 1c, which can control an AC current flowing bi-directionally by means of a single device, are employed for these switching devices SW. Hence, one power device is enough to constitute the one of the single switching devices SW, so that the number of power devices can be remarkably reduced in the matrix converter, thereby downsizing scale of circuitry and cooling mechanism and simplifying them as compared to the conventional converter.

### (Second Embodiment)

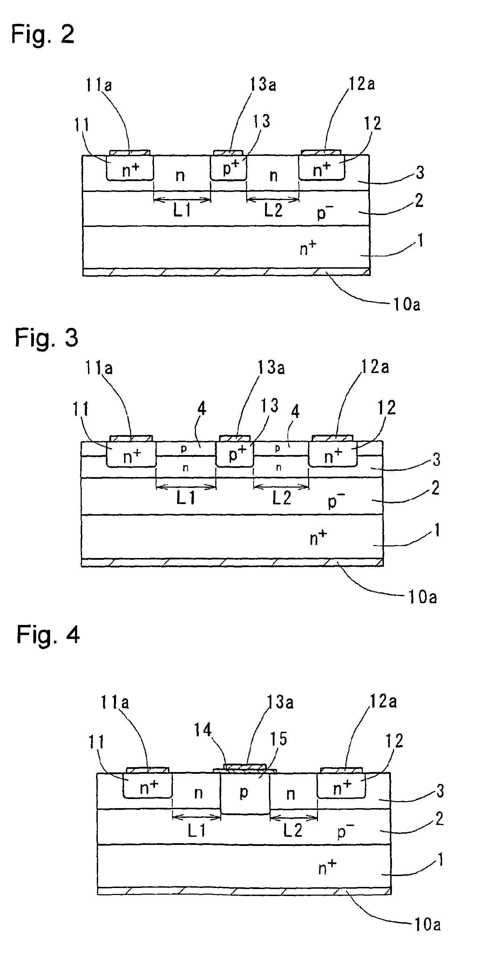

Fig. 2 is a cross-sectional view showing an example of a bidirectional field-effect transistor according to the present invention. Herein, a junction field-effect transistor (J-FET) will be exemplified.

On a substrate 1 formed is a buffer layer 2, on which a channel layer 3 is formed. In the channel layer 3, there are a gate region including a channel parallel to the principal surface of the substrate 1, a first region which is provided on a first side of the channel (left side of the drawing), and a second region which is provided on a second side of the channel (right side of the drawing).

In the gate region, provided is a gate electrode 13a for controlling conductance of the channel. In the first region, provided is a first electrode 11a which can act as either source electrode or drain electrode. In the second region, provided is a second electrode 12a which can act as either drain electrode or source electrode in contrast to the first electrode 11a. Both between the gate region and the first region and between the gate region and the second region, formed are drift regions through which majority carriers can pass.

The substrate 1 can be formed of a wafer of semiconductor, such as Si, SiC, GaN, herein, which is formed of an n⁺ layer having a relatively higher carrier concentration. On the back side of the substrate 1, formed is a common electrode 10a which is typically grounded.

In particular, the substrate 1 and the respective layers 2 and 3 are preferably formed of semiconductor material of SiC, which has excellent physical properties of approximately three times larger energy gap, approximately ten times higher electric breakdown field, approximately twice higher saturation electron velocity, and approximately three times larger thermal conductivity than Si, thereby resulting in a power FET device with a small size and large capacity.

The buffer layer 2 is epitaxially grown using chemical vapor deposition (CVD) or the like, herein, which is formed of a p⁻ layer having a relatively lower carrier concentration.

The channel layer 3 is also epitaxially grown using chemical vapor deposition (CVD) or the like, herein, which is formed of an n layer having a normal carrier concentration.

In the gate region of the channel layer 3, formed is a p⁺ layer 13 having a relatively higher carrier concentration by diffusion or ion implantation of a p-type dopant. On the p⁺ layer 13, the gate electrode 13a is formed. In the first region of the channel layer 3, formed is an n⁺ contact layer 11 having a relatively higher carrier concentration by diffusion or ion implantation of an n-type dopant. On the n⁺ contact layer 11, the first electrode 11a is formed. In the second region of the channel layer 3, formed is an n⁺ contact layer 12 having a relatively higher carrier concentration by diffusion or ion implantation of an n-type dopant. On the n⁺ contact layer 12, the second electrode 12a is formed.

Next, operation of this device will be described below. When a positive voltage +V is applied to the first electrode 11a and a negative voltage -V is applied to the second electrode 12a with a reference voltage (= 0 volt) of the common electrode 10a, a forward current flows through the path from the first electrode 11a via the n⁺ contact layer 11, the left drift region, the channel within the gate region, the right drift region and the n⁺ contact layer 12 to the second electrode 12a. In this state, a negative gate voltage is applied to the gate electrode 13a, so that a depletion layer emerges around the p-n junction of the p⁺ layer 13 and the n-type channel layer 3 to reduce conductance of the channel within the gate region, thereby increasing resistance of the path and suppressing the forward current.

Meanwhile, when a negative voltage -V is applied to the first electrode 11a and a positive voltage +V is applied to the second electrode 12a, a backward current flows through the path from the second electrode 12a via the n⁺ contact layer 12, the right drift region, the channel within the gate region, the left drift region and the n⁺ contact layer 11 to the first electrode 11a. In this state, a negative gate voltage is applied to the gate electrode 13a, so that a depletion layer emerges around the p-n junction of the p⁺ layer 13 and the n-type channel layer 3 to reduce conductance of the channel within the gate region, thereby increasing resistance of the path and suppressing the backward current.

Thus, the first and second electrodes 11a and 12a can alternately act as source electrode or drain electrode, and an AC current flowing bi-directionally can be controlled by changing the gate voltage.

In a case of controlling an AC power as in the above-mentioned matrix converter, it is preferable that forward characteristics and backward characteristics of the bidirectional field-effect transistor (for example, drain current vs. drain-source voltage, drain current vs. gate-source voltage, on-resistance, gate-source capacitance, reverse voltage, etc) are substantially equal to each other.

For an approach, the gate region including the gate electrode 13a is preferably arranged in the center of the first region including the first electrode 11a and the second region including the second electrode 12a. Thus, the length L1 of the left drift region is equal to the length L2 of the right drift region, thereby substantially equalizing forward and backward characteristics with each other.

For another approach, an interval between the gate electrode 13a and the first electrode 11a is preferably substantially equal to another interval between the gate electrode 13a and the second electrode 12a, thereby substantially equalizing forward and backward characteristics with each other.

For yet another approach, an interval between the channel of the gate region and the n⁺ contact layer 11 is preferably substantially equal to another interval between the channel of the gate region and the n⁺ second contact layer 12, thereby substantially equalizing forward and backward characteristics with each other.

For still yet another approach, the carrier concentration of the n⁺ contact layer 11 is preferably substantially equal to the carrier concentration of the n⁺ contact layer 12, thereby substantially equalizing forward and backward characteristics with each other.

For still yet another approach, a depth of the n⁺ contact layer 11 is preferably substantially equal to a depth of the n⁺ contact layer 12, thereby substantially equalizing forward and backward characteristics with each other.

### (Third Embodiment)

Fig. 3 is a cross-sectional view showing another example of a bidirectional field-effect transistor according to the present invention. Herein, a junction field-effect transistor (J-FET) having a RESURF (Reduced Surface Field) layer will be exemplified.

On a substrate 1 formed is a buffer layer 2, on which a channel layer 3 is formed. A RESURF layer 4 is formed on the channel layer 3. In the channel layer 3 and the RESURF layer 4, there are a gate region including a channel parallel to the principal surface of the substrate 1, a first region which is provided on a first side of the channel (left side of the drawing), and a second region which is provided on a second side of the channel (right side of the drawing).

In the gate region, provided is a gate electrode 13a for controlling conductance of the channel. In the first region, provided is a first electrode 11a which can act as either source electrode or drain electrode. In the second region, provided is a second electrode 12a which can act as either drain electrode or source electrode in contrast to the first electrode 11a. Both between the gate region and the first region and between the gate region and the second region, formed are drift regions through which majority carriers can pass.

The substrate 1 can be formed of a wafer of semiconductor, such as Si, SiC, GaN, herein, which is formed of an n⁺ layer having a relatively higher carrier concentration. On the back side of the substrate 1, formed is a common electrode 10a which is typically grounded.

In particular, the substrate 1 and the respective layers 2 and 3 are preferably formed of semiconductor material of SiC, which has excellent physical properties of approximately three times larger energy gap, approximately ten times higher electric breakdown field, approximately twice higher saturation electron velocity, and approximately three times larger thermal conductivity than Si, thereby resulting in a power FET device with a small size and large capacity.

The buffer layer 2 is epitaxially grown using chemical vapor deposition (CVD) or the like, herein, which is formed of a p⁻ layer having a relatively lower carrier concentration.

The channel layer 3 and the RESURF layer 4 are also epitaxially grown using chemical vapor deposition (CVD) or the like. Herein, the channel layer 3 is formed of an n layer having a normal carrier concentration.

The RESURF layer 4 is formed of a p layer having a normal carrier concentration by diffusion or ion implantation of a p-type dopant. Hence, the drift regions may also contain p-n junctions to relax concentration of electric fields near the surface, thereby improving reverse voltage property.

In the gate region, formed is a p⁺ layer 13 having a relatively higher carrier concentration by diffusion or ion implantation of a p-type dopant. On the p⁺ layer 13, the gate electrode 13a is formed. In the first region, formed is an n⁺ contact layer 11 having a relatively higher carrier concentration by diffusion or ion implantation of an n-type dopant. On the n⁺ contact layer 11, the first electrode 11a is formed. In the second region, formed is an n⁺ contact layer 12 having a relatively higher carrier concentration by diffusion or ion implantation of an n-type dopant. On the n⁺ contact layer 12, the second electrode 12a is formed.

Next, operation of this device will be described below. When a positive voltage +V is applied to the first electrode 11a and a negative voltage -V is applied to the second electrode 12a with a reference voltage (= 0 volt) of the common electrode 10a, a forward current flows through the path from the first electrode 11a via the n⁺ contact layer 11, the left drift region, the channel within the gate region, the right drift region and the n⁺ contact layer 12 to the second electrode 12a. In this state, a negative gate voltage is applied to the gate electrode 13a, so that a depletion layer emerges around the p-n junction of the p⁺ layer 13 and the n-type channel layer 3 to reduce conductance of the channel within the gate region, thereby increasing resistance of the path and suppressing the forward current.

Meanwhile, when a negative voltage -V is applied to the first electrode 11a and a positive voltage +V is applied to the second electrode 12a, a backward current flows through the path from the second electrode 12a via the n⁺ contact layer 12, the right drift region, the channel within the gate region, the left drift region and the n⁺ contact layer 11 to the first electrode 11a. In this state, a negative gate voltage is applied to the gate electrode 13a, so that a depletion layer emerges around the p-n junction of the p⁺ layer 13 and the n-type channel layer 3 to reduce conductance of the channel within the gate region, thereby increasing resistance of the path and suppressing the backward current.

Thus, the first and second electrodes 11a and 12a can alternately act as source electrode or drain electrode, and an AC current flowing bi-directionally can be controlled by changing the gate voltage.

In a case of controlling an AC power as in the above-mentioned matrix converter, it is preferable that forward characteristics and backward characteristics of the bidirectional field-effect transistor (for example, drain current vs. drain-source voltage, drain current vs. gate-source voltage, on-resistance, gate-source capacitance, reverse voltage, etc) are substantially equal to each other.

For an approach, the gate region including the gate electrode 13a is preferably arranged in the center of the first region including the first electrode 11a and the second region including the second electrode 12a. Thus, the length L1 of the left drift region is equal to the length L2 of the right drift region, thereby substantially equalizing forward and backward characteristics with each other.

For another approach, an interval between the gate electrode 13a and the first electrode 11a is preferably substantially equal to another interval between the gate electrode 13a and the second electrode 12a, thereby substantially equalizing forward and backward characteristics with each other.

For yet another approach, an interval between the channel of the gate region and the n⁺ contact layer 11 is preferably substantially equal to another interval between the channel of the gate region and the n⁺ second contact layer 12, thereby substantially equalizing forward and backward characteristics with each other.

For still yet another approach, the carrier concentration of the n⁺ contact layer 11 is preferably substantially equal to the carrier concentration of the n⁺ contact layer 12, thereby substantially equalizing forward and backward characteristics with each other.

For still yet another approach, a depth of the n⁺ contact layer 11 is preferably substantially equal to a depth of the n⁺ contact layer 12, thereby substantially equalizing forward and backward characteristics with each other.

### (Fourth Embodiment)

Fig. 4 is a cross-sectional view showing yet another example of a bidirectional field-effect transistor according to the present invention. Herein, a MOS (Metal-Oxide-Semiconductor) FET having a metal layer, an oxide layer and a semiconductor layer in a gate region will be exemplified. When using a general electric insulation layer instead of the oxide layer, a generic MIS (Metal-Insulator-Semiconductor) FET can be configured. In the case of MIS-FET, application of a bias voltage to the metal layer can cause an inversion layer around an interface between the semiconductor layer and the insulation layer. The inversion layer may act as a channel for carriers.

On a substrate 1 formed is a buffer layer 2, on which a channel layer 3 is formed. In the channel layer 3, there are a gate region including a channel parallel to the principal surface of the substrate 1, a first region which is provided on a first side of the channel (left side of the drawing), and a second region which is provided on a second side of the channel (right side of the drawing).

In the gate region, provided are an insulation layer 14, which is formed on the channel layer 3, and a gate electrode 13a for controlling conductance of the channel. In the first region, provided is a first electrode 11a which can act as either source electrode or drain electrode. In the second region, provided is a second electrode 12a which can act as either drain electrode or source electrode in contrast to the first electrode 11a. Both between the gate region and the first region and between the gate region and the second region, formed are drift regions through which majority carriers can pass.

The substrate 1 can be formed of a wafer of semiconductor, such as Si, SiC, GaN, herein, which is formed of an n⁺ layer having a relatively higher carrier concentration. On the back side of the substrate 1, formed is a common electrode 10a which is typically grounded.

In particular, the substrate 1 and the respective layers 2 and 3 are preferably formed of semiconductor material of SiC, which has excellent physical properties of approximately three times larger energy gap, approximately ten times higher electric breakdown field, approximately twice higher saturation electron velocity, and approximately three times larger thermal conductivity than Si, thereby resulting in a power FET device with a small size and large capacity. In addition, when the channel layer 3 is formed of SiC, the insulation layer 14 can be formed of SiO₂, similarly to a Si-based MOS-FET, by an oxidation process using a mask having a predetermined opening.

The buffer layer 2 is epitaxially grown using chemical vapor deposition (CVD) or the like, herein, which is formed of a p⁻ layer having a relatively lower carrier concentration.

The channel layer 3 is also epitaxially grown using chemical vapor deposition (CVD) or the like, herein, which is formed of an n layer having a normal carrier concentration.

In the gate region, formed is a p layer 15 having a normal carrier concentration by diffusion or ion implantation of a p-type dopant. On the p layer 15, the gate electrode 13a is formed. In the first region, formed is an n⁺ contact layer 11 having a relatively higher carrier concentration by diffusion or ion implantation of an n-type dopant. On the n⁺ contact layer 11, the first electrode 11a is formed. In the second region, formed is an n⁺ contact layer 12 having a relatively higher carrier concentration by diffusion or ion implantation of an n-type dopant. On the n⁺ contact layer 12, the second electrode 12a is formed.

Next, operation of this device will be described below. When a positive gate voltage is applied to the gate electrode 13a with a reference voltage (= 0 volt) of the common electrode 10a, the inversion layer which can act as a channel is induced. In this state, when a positive voltage +V is applied to the first electrode 11a and a negative voltage -V is applied to the second electrode 12a, a forward current flows through the path from the first electrode 11a via the n⁺ contact layer 11, the left drift region, the channel within the gate region, the right drift region and the n⁺ contact layer 12 to the second electrode 12a. Next, a negative gate voltage is applied to the gate electrode 13a, so that the inversion layer disappears to reduce conductance of the channel, thereby increasing resistance of the path and suppressing the forward current.

Meanwhile, in a state of applying a positive gate voltage to the gate electrode 13a, when a negative voltage -V is applied to the first electrode 11a and a positive voltage +V is applied to the second electrode 12a, a backward current flows through the path from the second electrode 12a via the n⁺ contact layer 12, the right drift region, the channel within the gate region, the left drift region and the n⁺ contact layer 11 to the first electrode 11a. Next, a negative gate voltage is applied to the gate electrode 13a to reduce conductance of the channel, thereby increasing resistance of the path and suppressing the backward current.

Thus, the first and second electrodes 11a and 12a can alternately act as source electrode or drain electrode, and an AC current flowing bi-directionally can be controlled by changing the gate voltage. Incidentally, a range of the gate voltage to be changed may be optionally designed depending on an enhancement or depression mode of characteristics of MOS-FET.

In a case of controlling an AC power as in the above-mentioned matrix converter, it is preferable that forward characteristics and backward characteristics of the bidirectional field-effect transistor (for example, drain current vs. drain-source voltage, drain current vs. gate-source voltage, on-resistance, gate-source capacitance, reverse voltage, etc) are substantially equal to each other.

For an approach, the gate region including the gate electrode 13a is preferably arranged in the center of the first region including the first electrode 11a and the second region including the second electrode 12a. Thus, the length L1 of the left drift region is equal to the length L2 of the right drift region, thereby substantially equalizing forward and backward characteristics with each other.

For another approach, an interval between the gate electrode 13a and the first electrode 11a is preferably substantially equal to another interval between the gate electrode 13a and the second electrode 12a, thereby substantially equalizing forward and backward characteristics with each other.

For yet another approach, an interval between the channel of the gate region and the n⁺ contact layer 11 is preferably substantially equal to another interval between the channel of the gate region and the n⁺ second contact layer 12, thereby substantially equalizing forward and backward characteristics with each other.

For still yet another approach, the carrier concentration of the n⁺ contact layer 11 is preferably substantially equal to the carrier concentration of the n⁺ contact layer 12, thereby substantially equalizing forward and backward characteristics with each other.

For still yet another approach, a depth of the n⁺ contact layer 11 is preferably substantially equal to a depth of the n⁺ contact layer 12, thereby substantially equalizing forward and backward characteristics with each other.

### (Fifth Embodiment)

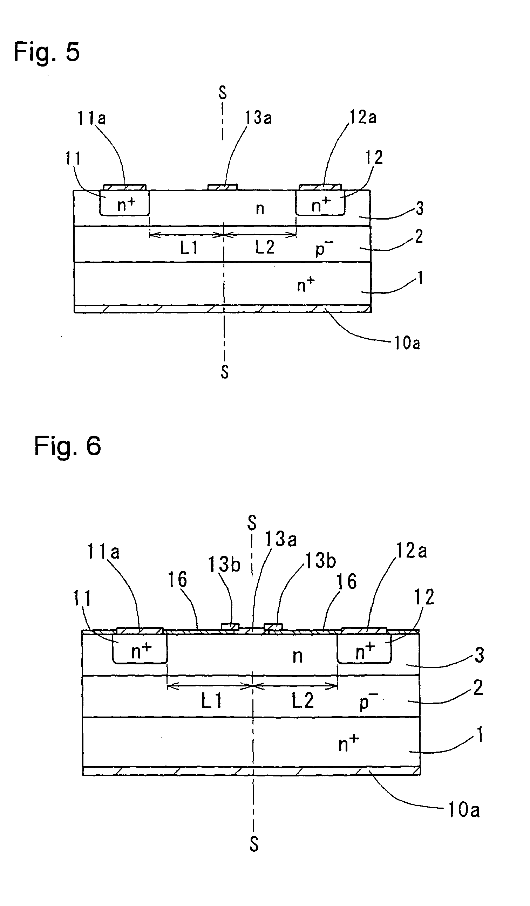

Fig. 5 is a cross-sectional view showing still yet another example of a bidirectional field-effect transistor according to the present invention. Herein, a MES (Metal-Semiconductor) FET having a Schottky junction of a metal and a semiconductor will be exemplified. In the case of MES-FET, a depletion layer which is caused by the Schottky junction can change conductance of a channel.

On a substrate 1 formed is a buffer layer 2, on which a channel layer 3 is formed. In the channel layer 3, there are a gate region including a channel parallel to the principal surface of the substrate 1, a first region which is provided on a first side of the channel (left side of the drawing), and a second region which is provided on a second side of the channel (right side of the drawing).

In the gate region, provided is a gate electrode 13a for controlling conductance of the channel. In the first region, provided is a first electrode 11a which can act as either source electrode or drain electrode. In the second region, provided is a second electrode 12a which can act as either drain electrode or source electrode in contrast to the first electrode 11a. Both between the gate region and the first region and between the gate region and the second region, formed are drift regions through which majority carriers can pass.

The substrate 1 can be formed of a wafer of semiconductor, such as Si, SiC, GaN, herein, which is formed of an n⁺ layer having a relatively higher carrier concentration. On the back side of the substrate 1, formed is a common electrode 10a which is typically grounded.

In particular, the substrate 1 and the respective layers 2 and 3 are preferably formed of semiconductor material of SiC, which has excellent physical properties of approximately three times larger energy gap, approximately ten times higher electric breakdown field, approximately twice higher saturation electron velocity, and approximately three times larger thermal conductivity than Si, thereby resulting in a power FET device with a small size and large capacity.

The buffer layer 2 is epitaxially grown using chemical vapor deposition (CVD) or the like, herein, which is formed of a p⁻ layer having a relatively lower carrier concentration.

The channel layer 3 is also epitaxially grown using chemical vapor deposition (CVD) or the like, herein, which is formed of an n layer having a normal carrier concentration.

In the gate region, the gate electrode 13a is formed directly on the channel layer 3. In the first region, formed is an n⁺ contact layer 11 having a relatively higher carrier concentration by diffusion or ion implantation of an n-type dopant. On the n⁺ contact layer 11, the first electrode 11a is formed. In the second region, formed is an n⁺ contact layer 12 having a relatively higher carrier concentration by diffusion or ion implantation of an n-type dopant. On the n⁺ contact layer 12, the second electrode 12a is formed.

Next, operation of this device will be described below. When a positive gate voltage is applied to the gate electrode 13a with a reference voltage (= 0 volt) of the common electrode 10a, the depletion layer in the gate region is reduced. In this state, when a positive voltage +V is applied to the first electrode 11a and a negative voltage -V is applied to the second electrode 12a, a forward current flows through the path from the first electrode 11a via the n⁺ contact layer 11, the left drift region, the channel within the gate region, the right drift region and the n⁺ contact layer 12 to the second electrode 12a. Next, a negative gate voltage is applied to the gate electrode 13a, so that the depletion layer is increased to reduce conductance of the channel, thereby increasing resistance of the path and suppressing the forward current.

Meanwhile, in a state of applying a positive gate voltage to the gate electrode 13a, when a negative voltage -V is applied to the first electrode 11a and a positive voltage +V is applied to the second electrode 12a, a backward current flows through the path from the second electrode 12a via the n⁺ contact layer 12, the right drift region, the channel within the gate region, the left drift region and the n⁺ contact layer 11 to the first electrode 11a. Next, a negative gate voltage is applied to the gate electrode 13a to reduce conductance of the channel, thereby increasing resistance of the path and suppressing the backward current.

Thus, the first and second electrodes 11a and 12a can alternately act as source electrode or drain electrode, and an AC current flowing bi-directionally can be controlled by changing the gate voltage.

In a case of controlling an AC power as in the above-mentioned matrix converter, it is preferable that forward characteristics and backward characteristics of the bidirectional field-effect transistor (for example, drain current vs. drain-source voltage, drain current vs. gate-source voltage, on-resistance, gate-source capacitance, reverse voltage, etc) are substantially equal to each other.

For an approach, the gate region including the gate electrode 13a is preferably arranged in the center of the first region including the first electrode 11a and the second region including the second electrode 12a, i.e., as shown in Fig. 5, the distance L1 between the center line S of the gate region and the first region is preferably equal to the length L2 of the center line S of the gate region and the second region. Thus, the length L1 of the left drift region is equal to the length L2 of the right drift region, thereby substantially equalizing forward and backward characteristics with each other.

For another approach, an interval between the gate electrode 13a and the first electrode 11a is preferably substantially equal to another interval between the gate electrode 13a and the second electrode 12a, thereby substantially equalizing forward and backward characteristics with each other.

For yet another approach, an interval between the channel of the gate region and the n⁺ contact layer 11 is preferably substantially equal to another interval between the channel of the gate region and the n⁺ second contact layer 12, thereby substantially equalizing forward and backward characteristics with each other.

For still yet another approach, the carrier concentration of the n⁺ contact layer 11 is preferably substantially equal to the carrier concentration of the n-contact layer 12, thereby substantially equalizing forward and backward characteristics with each other.

For still yet another approach, a depth of the n⁺ contact layer 11 is preferably substantially equal to a depth of the n⁺ contact layer 12, thereby substantially equalizing forward and backward characteristics with each other.

### (Sixth Embodiment)

Fig. 6 is a cross-sectional view showing still yet another example of a bidirectional field-effect transistor according to the present invention. Herein, a MES-FET having a field plate structure will be exemplified. Such a field plate structure is provided for relaxing concentration of electric fields inside the semiconductor and improving a breakdown voltage. Herein, exemplified is the field plate structure being located near a gate electrode, but it may be located near a source or drain electrode.

On a substrate 1 formed is a buffer layer 2, on which a channel layer 3 is formed. In the channel layer 3, there are a gate region including a channel parallel to the principal surface of the substrate 1, a first region which is provided on a first side of the channel (left side of the drawing), and a second region which is provided on a second side of the channel (right side of the drawing).

In the gate region, provided is a gate electrode 13a for controlling conductance of the channel. In the first region, provided is a first electrode 11a which can act as either source electrode or drain electrode. In the second region, provided is a second electrode 12a which can act as either drain electrode or source electrode in contrast to the first electrode 11a. Both between the gate region and the first region and between the gate region and the second region, formed are drift regions through which majority carriers can pass.

The substrate 1 can be formed of a wafer of semiconductor, such as Si, SiC, GaN, herein, which is formed of an n⁺ layer having a relatively higher carrier concentration. On the back side of the substrate 1, formed is a common electrode 10a which is typically grounded.

In particular, the substrate 1 and the respective layers 2 and 3 are preferably formed of semiconductor material of SiC, which has excellent physical properties of approximately three times larger energy gap, approximately ten times higher electric breakdown field, approximately twice higher saturation electron velocity, and approximately three times larger thermal conductivity than Si, thereby resulting in a power FET device with a small size and large capacity.

The buffer layer 2 is epitaxially grown using chemical vapor deposition (CVD) or the like, herein, which is formed of a p⁻ layer having a relatively lower carrier concentration.

The channel layer 3 is also epitaxially grown using chemical vapor deposition (CVD) or the like, herein, which is formed of an n layer having a normal carrier concentration. On the channel layer 3, an insulation layer 16 of SiO₂ is formed except for each location of the electrodes.

In the gate region, the gate electrode 13a is formed directly on the channel layer 3, and an electrically conductive field plates 13b are provided on the insulation layer 16 so as to surround the peripheral edge of the gate electrode 13a. Since concentration of electric fields takes place near the edge of the gate electrode 13a inside the channel layer 3, the field plates 13b can function so as to relax concentration of electric fields near the edge.

In the first region, formed is an n⁺ contact layer 11 having a relatively higher carrier concentration by diffusion or ion implantation of an n-type dopant. On the n⁺ contact layer 11, the first electrode 11a is formed. In the second region, formed is an n⁺ contact layer 12 having a relatively higher carrier concentration by diffusion or ion implantation of an n-type dopant. On the n⁺ contact layer 12, the second electrode 12a is formed.

Next, operation of this device will be described below. When a positive gate voltage is applied to the gate electrode 13a with a reference voltage (= 0 volt) of the common electrode 10a, the depletion layer in the gate region is reduced. In this state, when a positive voltage +V is applied to the first electrode 11a and a negative voltage -V is applied to the second electrode 12a, a forward current flows through the path from the first electrode 11a via the n⁺ contact layer 11, the left drift region, the channel within the gate region, the right drift region and the n⁺ contact layer 12 to the second electrode 12a. Next, a negative gate voltage is applied to the gate electrode 13a, so that the depletion layer is increased to reduce conductance of the channel, thereby increasing resistance of the path and suppressing the forward current.

Meanwhile, in a state of applying a positive gate voltage to the gate electrode 13a, when a negative voltage -V is applied to the first electrode 11a and a positive voltage +V is applied to the second electrode 12a, a backward current flows through the path from the second electrode 12a via the n⁺ contact layer 12, the right drift region, the channel within the gate region, the left drift region and the n⁺ contact layer 11 to the first electrode 11a. Next, a negative gate voltage is applied to the gate electrode 13a to reduce conductance of the channel, thereby increasing resistance of the path and suppressing the backward current.

Thus, the first and second electrodes 11a and 12a can alternately act as source electrode or drain electrode, and an AC current flowing bi-directionally can be controlled by changing the gate voltage.

In a case of controlling an AC power as in the above-mentioned matrix converter, it is preferable that forward characteristics and backward characteristics of the bidirectional field-effect transistor (for example, drain current vs. drain-source voltage, drain current vs. gate-source voltage, on-resistance, gate-source capacitance, reverse voltage, etc) are substantially equal to each other.

For an approach, the gate region including the gate electrode 13a is preferably arranged in the center of the first region including the first electrode 11a and the second region including the second electrode 12a, i.e., as shown in Fig. 6, the distance L1 between the center line S of the gate region and the first region is preferably equal to the length L2 of the center line S of the gate region and the second region. Thus, the length L1 of the left drift region is equal to the length L2 of the right drift region, thereby substantially equalizing forward and backward characteristics with each other.

For another approach, an interval between the gate electrode 13a and the first electrode 11a is preferably substantially equal to another interval between the gate electrode 13a and the second electrode 12a, thereby substantially equalizing forward and backward characteristics with each other.

For yet another approach, an interval between the channel of the gate region and the n⁺ contact layer 11 is preferably substantially equal to another interval between the channel of the gate region and the n⁺ second contact layer 12, thereby substantially equalizing forward and backward characteristics with each other.

For still yet another approach, the carrier concentration of the n⁺ contact layer 11 is preferably substantially equal to the carrier concentration of the n⁺ contact layer 12, thereby substantially equalizing forward and backward characteristics with each other.

For still yet another approach, a depth of the n⁺ contact layer 11 is preferably substantially equal to a depth of the n⁺ contact layer 12, thereby substantially equalizing forward and backward characteristics with each other.

Incidentally, in each of the above-described embodiments, the substrate 1 and the channel layer 3 are of n-conductivity type and the buffer layer 2, the RESURF layer 4 (Fig. 3) and the p layer 15 (Fig. 4) are of p-conductivity type. But the present invention can be also applied to a case of the respective layers having reverse conductivity type.

### [INDUSTRIAL APPLICABILITY]

The present invention proposes new bidirectional field-effect transistors, which are very useful in downsizing and upgrading in capacity various AC power control equipments, such as matrix converter.

## Claims

1. A bidirectional field-effect transistor comprising:
a semiconductor substrate;
a gate region which is formed on the semiconductor substrate, the region including a channel parallel to a principal surface of the substrate, and a gate electrode for controlling conductance of the channel;
a first region which is provided on a first side of the channel; and
a second region which is provided on a second side of the channel;
wherein both of a first current flowing from the first region through the channel to the second region and a second current flowing from the second region through the channel to the first region are controlled by a gate voltage applied to the gate electrode.

2. The bidirectional field-effect transistor according to Claim 1, wherein the gate region is arranged in the center of the first region and the second region.

3. The bidirectional field-effect transistor according to Claim 1, wherein an interval between the gate electrode and a first electrode residing in the first region is substantially equal to another interval between the gate electrode and a second electrode residing in the second region.

4. The bidirectional field-effect transistor according to Claim 1, wherein an interval between the channel of the gate region and a first contact layer residing in the first region is substantially equal to another interval between the channel of the gate region and a second contact layer residing in the second region.

5. The bidirectional field-effect transistor according to Claim 1, wherein the transistor is of junction type wherein the gate region includes a p-n junction.

6. The bidirectional field-effect transistor according to Claim 1, wherein the transistor is of MIS type wherein the gate region includes a metal layer, an insulation layer and a semiconductor layer.

7. The bidirectional field-effect transistor according to Claim 1, wherein the transistor is of MES type wherein the gate region includes a Schottky junction of a metal and a semiconductor.

8. The bidirectional field-effect transistor according to Claim 1, wherein the semiconductor substrate is formed of SiC.

9. A matrix converter comprising:
a plurality of input lines in which alternating currents having a first frequency flow;
a plurality of output lines in which alternating currents having a second frequency flow;
a plurality of switching devices for controlling opening and closing between the respective input lines and the respective output lines;
wherein for the switching devices, the bidirectional field-effect transistors according to any one of Claims 1 to 8 are used.
